# EUROPEAN PATENT APPLICATION

(11) **EP 4 542 654 A1**
(43) Date of publication of application: **23.04.2025**
(21) Application number: 23204901.5
(22) Date of filing: 20.10.2023
(51) Int. Cl.: H01L 29/40, H01L 29/06, H01L 29/78, H01L 29/739

(54) **A SEMICONDUCTOR SWITCHING DEVICE IMPLEMENTING AN EDGE TERMINATION STRUCTURE**

(71) Applicant: Nexperia B.V., 6534 AB Nijmegen (NL)
(72) Inventor: Nida, Selamnesh, München (DE); Xiang, Junli, Shanghai (CN)
(74) Representative: Pjanovic, Ilija

(57) **Abstract**

According to a first example of the disclosure, a semiconductor switching device implementing an edge termination structure is proposed. The semiconductor switching device comprises a semiconductor die formed by a first region (111) doped with a first type of charge carriers and having a center area (100y) and a peripheral area (100z) surrounding the center area, and at least one junction provided in the center area of the semiconductor die, the junction being formed with respect to a second region doped with a second type of charge carriers different from the first type of charge carriers, with the second region adjoining the first region.

An edge termination structure is provided in the edge area (100z) and surrounding the center area (100y), and structured to prevent voltage breakdown during operation of the semiconductor switching device, the edge termination structure being composed of are least one ring structure (113, 120) provided in the first region, wherein the at least ring one structure is composed of a series of spaced apart concentric ring sections (113) provided in the first region, each ring section being doped with the second type of charge carriers and being spaced apart by a spacing (120) doped with the first type of charge carriers. Each ring section is connected to a field plate (114).

## Description

### TECHNICAL FIELD

The present disclosure relates to a semiconductor switching device implementing an edge termination structure.

### BACKGROUND OF THE DISCLOSURE

Edge termination structures are intended to limit or to terminate the electric field within minimal length or for a given length of the termination, to increase the breakdown voltage (VBR) of a semiconductor switching device. In particular edge termination structures are intended to minimize the electric field peaks that often are cause of reliability failures of the device. However, depending on the doping profile and configuration, the electric field during the blocking state of an edge termination structure may still consist of maxima's and thus may still be the cause of reliability failures.

Accordingly, it is a goal of the present disclosure to provide an improved semiconductor switching device with an edge termination structure with an improved VBR and reliability.

### SUMMARY OF THE DISCLOSURE

According to a first example of the disclosure, a semiconductor switching device is proposed implementing an edge termination structure. The semiconductor switching device comprises a semiconductor die formed by a first region doped with a first type of charge carriers and the top section having a center area and a peripheral area surrounding the center area. At least one junction is provided in the center area of the semiconductor die, the junction being formed between a second region doped with a second type of charge carriers different from the first type of charge carriers, with the second region adjoining the first region.

In addition, an edge termination structure is provided in the edge area and surrounds the center area. The edge termination structure is structured to prevent voltage breakdown during operation of the semiconductor switching device, and composed of at least one ring structure provided at the edge of the first region.

The at least one ring structure is composed of a series of spaced apart concentric ring sections provided in the first region, each ring section being doped with the second type of charge carriers and being spaced apart by a spacing doped with the first type of charge carriers.

Accordingly, with the substitution of the currently implemented each wide ring with multiple narrow subrings which are provided concentric to each other the implantation (doping) profiles of the relevant charge carriers are spread smoothly in a lateral direction, The resulting electric field, which is a function of the doping, is smoothed out to get the advantages of the VLD-like profile within each ring. Accordingly, any electric field peaks that occur within the spacings at the various junctions of the ring sections are further reduced and thereby the VBR and the reliability are improved.

It should be noted, that the first type of charge carriers may be N-type carriers, whereas the second type of charge carriers may be P-type carriers. However, the reversed configuration, wherein the first type of charge carriers are P-type carriers and the second type of charge carriers are N-type carriers is equally appliable in achieving the desired effect of smoothening out electric field peaks and improving the VBR and the reliability.

In an example, the second region is formed as a well in the first region. Accordingly, such device can be manufactured in a logical sequence of manufacturing steps.

In an advantageous example, the number of subring sections is in the range of 3-10, in particular 3-8 and more in particular 3-5.

In particular, the lateral width of a subring section maybe in the range of 3-10 µm, in particular 3-6 µm and preferably 4 µm.

Likewise, a spacing between adjacent subring sections may be in the range of 4-10 µm, preferably 6-10 µm.

In a further advantageous example, the termination structure comprises a metal field plate element on top of the main ring section extending to the spacing between the main ring sections. The metal FP structure can increase the reliability in cases of suboptimal charge shielding of passivation layers.

### BRIEF DESCRIPTION OF THE DRAWINGS

The disclosure will now be discussed with reference to the drawings, which show in:
Figure 1A a semiconductor switching device implementing an edge termination structure according to the state of the art;
Figure 1B a field plate edge termination structure according to an example of the disclosure;
Figure 1C a detailed view of the example of Figure 1B;
Figure 2 a top view of the example of Figure 1B and 1C;
Figure 3 an improved breakdown voltage (VBR) for the Field plate termination example according to the disclosure compared with the state of the art
Figure 4A an electric field distribution profile for the standard structure of Figure 1A at 1200V;
Figure 4B an electric field distribution profile for the example of the disclosure at 1200V.

### DETAILED DESCRIPTION OF THE DISCLOSURE

For a proper understanding of the disclosure, in the detailed description below corresponding elements or parts of the disclosure will be denoted with identical reference numerals in the drawings.

Throughout the following detailed description it is understood, that the first type of charge carriers are N-type carriers, and the second type of charge carriers are logically P-type carriers. However, the reversed configuration, wherein the first type of charge carriers are P-type carriers and the second type of charge carriers are N-type carriers is equally appliable in all examples described in this application, as both configurations (NP or PN) achieve the desired effect of the disclosure.

As outlined in the introductory part of this application, edge termination structures are intended to limit or to terminate the electric field within minimal length or for a given length of the termination, to increase the breakdown voltage (VBR) of a semiconductor switching device. In particular edge termination structures are intended to minimize the electric field peaks that often are cause of reliability failures of the device.

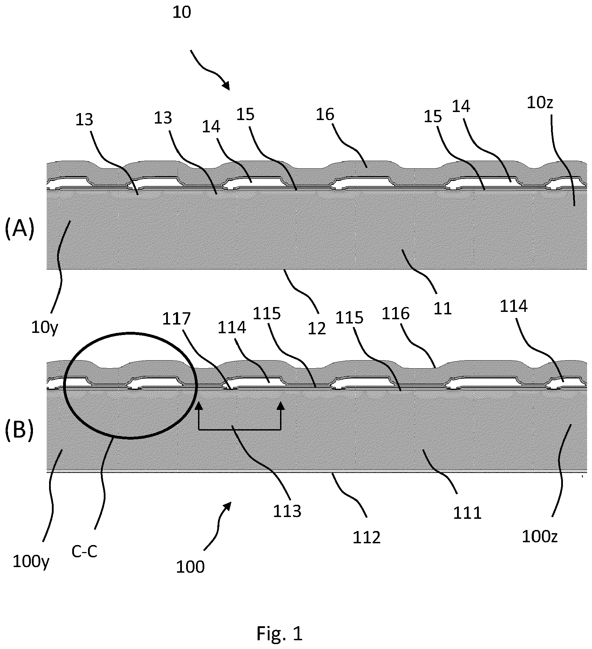

An example as known in the prior art is detailed in Figure 1A. Reference numeral 10 denotes a semiconductor switching device, yet is functionality or manner of operation is not detailed further. The device 10 is formed of a semiconductor die 11. The die 11 is formed by a first region doped with a first type of charge carriers. For the sake of clarity and explanation of the disclosure, it is assumed that the first type of charge carriers are N-type of charge carriers.

The semiconductor switching device 10 has a center area denoted with reference numeral 10y and a peripheral area surrounding the center area 10y, with the peripheral area being denoted with reference numeral 10z.

Although not relevant for a proper understanding of the disclosure, the center area 10y of the semiconductor die 11 may be provided with a junction usually being formed by a second region doped with a second type of charge carriers different from the first type of charge carriers, with the second region adjoining or above or on top of the first region.

Reference numeral 13 may denote an edge termination structure that is provided in the edge area 10z and that surrounds the center area 10y of the semiconductor die 11. The edge termination structure 13 is structured to prevent voltage breakdown during operation of the semiconductor switching device 10, and composed of at least one ring structure 13, that is provided in the first region doped with a first type of charge carriers, here in this example P-type carriers. Each ring structure 13 may be electrically connected with a metal field plate element 14, the latter being placed on top of the ring structure 13.

Between the metal plate element 14 and the semiconductor surface, an insulation layer 15 is provided. Reference numeral 16 denotes a polyamide humidity insulator, covering in an isolated manner the semiconductor die surface and the metal field plate elements 14. Reference numeral 12 may denote an electrode to apply a bias voltage.

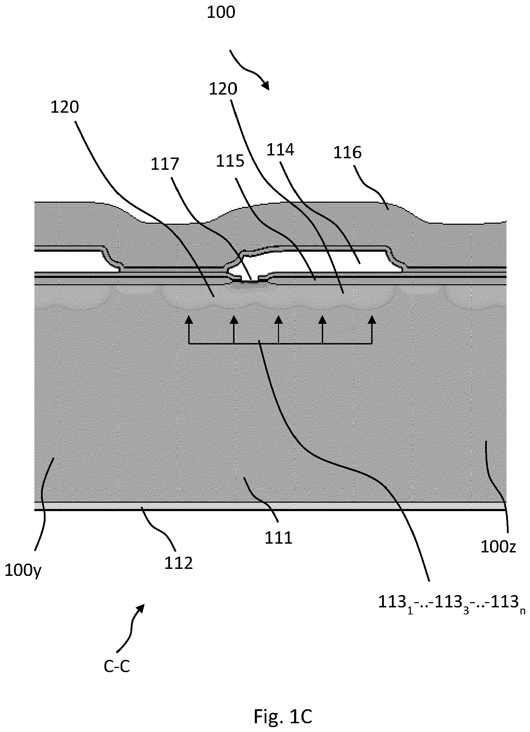

Figure 1B (accompanied by its detailed view C-C in Figure 1C) show an example of an improved semiconductor switching device with an edge termination structure exhibiting an improved VBR and reliability.

In Figure 1B and in its detailed enlargement C-C in Figure 1C, corresponding technical features taken from Figure 1A are denoted with a similar numeral referencing. In Figures 1B and 1C an example of a semiconductor switching device according to the disclosure is denoted with reference numeral 100. It is formed of a semiconductor die 111 having a first region doped with a first type of charge carriers, which could be P-type or N-type.

The center area of the semiconductor switching device 100 is denoted as 100y and a peripheral area 100z surrounding the center area 100y. Likewise, the center area 100y of the semiconductor die 111 may be provided with a junction usually being formed by a second region doped with a second type of charge carriers different from the first type of charge carriers, with the second region adjoining the first region.

The edge termination structure 113 of the disclosure is provided in the edge area 100z and surrounds in a similar fashion as in the prior art the center area 100y of the semiconductor die 111. The edge termination structure 113 according to the disclosure also prevents voltage breakdown during operation of the semiconductor switching device 100.

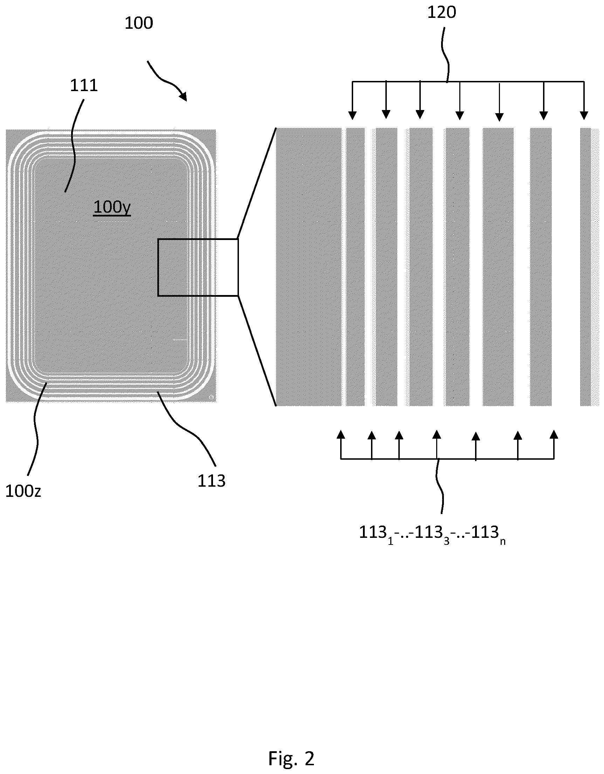

Contrary to the prior art edge termination structure 13, according to the present disclosure the edge termination structure 113 is formed as a ring structure composed of a series of spaced apart concentric ring sections. Each individual concentric ring section is denoted with reference numerals 113₁-..-113₃-..-113ₙ. The various individual concentrically oriented ring sections 113ₙ are present in the first region, and are each being doped with the second type of charge carriers. As seen in more detail in Figure 1C, the individual concentrically oriented ring sections 113ₙ are spaced apart by spacings 120. See also the top view in Figure 2.

By substituting of the single wide ring 13 as in the prior art of Figure 1A with multiple narrow ring sections 113ₙ which are provided concentric to each other in the semiconductor die structure 111 the doping profiles of the relevant charge carriers are spread in a lateral direction as well as deeper into the semiconductor device, hence towards the outer periphery 100z of the semiconductor switching device 100 as seen in a direction originating from the center area 100y towards the peripheral area 100z thereof. The resulting electric field, which is a function of the doping, is smoothed out to get the advantages of the VLD-like profile within the rings. Accordingly, large electric field peaks that occur within the wide spacings between the rings 13, are further reduced and thereby the VBR and the reliability of the semiconductor switching device 100 according to the disclosure are improved.

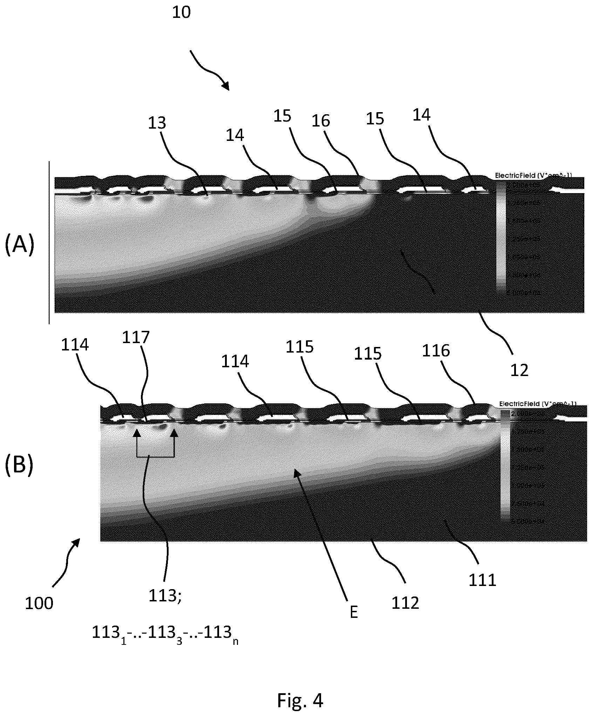

The above advantageous effects on the electric field are shown in Figure 4A and 4B, showing the electric field distribution profiles E for the standard structure of Figure 1A and for the example of the disclosure, Figure 1B, both at 1200V. In Figure 4B, depicting an example according to the disclosure, the generated electric field E is spread across the semiconductor die structure 111, as compared with the known state-of-the-art device 10 as depicted in Figure 1A.

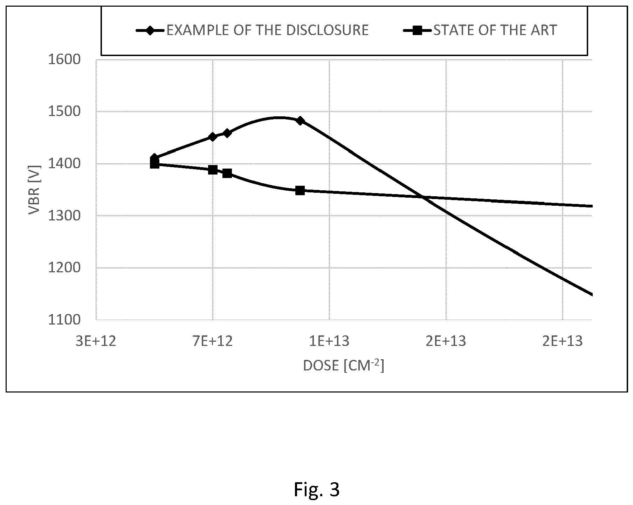

The configuration of the edge termination structure 113 by means of multiple narrow ring sections 113ₙ results in the VBR increase, as shown in Figure 3 from 1348 V to 1500 V, which is considered an improvement of approx. 150 V (=10%) compared to the state of the art example (also depicted in the same graph). An overall improvement in VBR was observed for the implant dose of 5×10¹² and 1.5×10¹³.

The reliability of the new configuration of the disclosure, that is the substitution of the single wide ring 13 as in the prior art with multiple narrow ring sections 113ₙ according to the disclosure, is also expected to be better. In cases of high humidity and cosmic ray events as well as in suboptimal passivation of external charges, the semiconductor switching device 100 according to the disclosure becomes robust since the sensitive high electric field peaks are pushed away from the surface and their amplitude is diminished.

Resulting from this doping profile due to the multiple concentric ring sections 113ₙ the electric field during the blocking state of a FP structure (Figures 1B and 1C) consists of maxima's in the gaps 120 between the concentric ring sections 113ₙ, and minima's, inside the concentric ring sections 113ₙ. It also includes another maxima in the large gaps between rings 113.

In an FP example, the known single p-implanted ring structure 13 is substituted with 3-5 individual concentric ring sections 113ₙ with a ~3-10µm width of ring sections 113ₙ and 4-10 µm width of spacings 120. After diffusion, these concentric ring sections 113ₙ become partially inter-diffused spreading the doping evenly inside the ring sections 113ₙ.

Likewise, each ring structure 113 may be electrically connected with a metal field plate element 114, the latter being placed on top of the ring structure 113. In more detail, each metal field plate element 114 may be electrically connected at one of the spaced apart concentric ring sections 113ₙ, the contact section is denoted with reference numeral 117, see in particular the more detailed Figure 1C.

Similarly, between the metal plate element 114 and (the first region doped with the first type of charge carriers of) the semiconductor die 111 an insulation layer 115 is provided. The metal plate structure 114 can increase the reliability in cases of suboptimal charge shielding of passivation layers. Also, reference numeral 116 denotes a passivation layer covering the insulation layer 115 and the associated metal field plate elements 114. Likewise, reference numeral 112 may denote a contact implant and an electrode to apply a bias voltage.

In an example, the second region is formed as a well in the first region. Accordingly, such device can be manufactured in a logical sequence of manufacturing steps.

In an advantageous example, the number n of ring sections 113ₙ is in the range of 3-10, in particular 3-8 and more in particular 3-5.

In particular, the lateral width of a ring section 113ₙ maybe in the range of 3-10 µm, in particular 3-6 µm and preferably 4 µm.

Likewise, a spacing 120 between adjacent ring sections 113ₙ may be in the range of 4-10 µm, preferably 6-10 µm.

Aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

### LIST OF REFERENCE NUMERALS USED

- 10: semiconductor switching device according to the prior art
- 10y: center area
- 10z: peripheral area
- 11: semiconductor die structure
- 12: electrode
- 13: edge termination structure
- 14: metal field plate element
- 15: insulation layer
- 16: field shielding plate
- 100: semiconductor switching device according to the disclosure
- 100y: center area
- 100z: peripheral area
- 111: semiconductor die structure
- 112: electrode
- 113: edge termination structure according to the disclosure
- 113ₙ: spaced apart concentric ring sections
- 114: metal field plate element
- 115: insulation layer
- 116: field shielding plate
- 117: concentric ring section electrically connected with field shielding plate
- 120: spacing or pitch

## Claims

1. A semiconductor switching device implementing an edge termination structure, the semiconductor switching device comprising:
a semiconductor die formed by a first region doped with a first type of charge carriers and having a center area and a peripheral area surrounding the center area,
at least one junction provided in the center area of the semiconductor die, the junction being formed a second region doped with a second type of charge carriers different from the first type of charge carriers, with the second region adjoining the first region,
an edge termination structure provided in the edge area and surrounding the center area, and structured to prevent voltage breakdown during operation of the semiconductor switching device, the edge termination structure being composed of at least one ring structure provided in the first region, wherein
the at least ring one structure is composed of a series of spaced apart concentric ring sections provided in the first region, each ring section being doped with the second type of charge carriers and being spaced apart by a spacing doped with the first type of charge carriers.

2. The semiconductor switching device according to claim 1, wherein the first type of charge carriers are N-type carriers and the second type of charge carriers are P-type carriers.

3. The semiconductor switching device according to claim 1, wherein the first type of charge carriers are P-type carriers and the second type of charge carriers are N-type carriers.

4. The semiconductor switching device according to any one or more of the claims 1-3, wherein the second region is formed as a well in the first region.

5. The semiconductor switching device according to any one or more of the claims 1-3, wherein the first region and the second region are formed as layers, with the first region layer extending over the second region layer.

6. The semiconductor switching device according to any one or more of the claims 1-5, wherein the number of ring sections is in the range of 3-10, in particular 3-8 and more in particular 3-5.

7. The semiconductor switching device according to any one or more of the claims 1-6, wherein a lateral width of a ring section is in the range of 3-10 µm, in particular 3-6 µm and preferably 4 µm.

8. The semiconductor switching device according to any one or more of the claims 1-7, wherein a spacing between adjacent ring sections is in the range of 4-10 µm, preferably 6-10 µm.
